# EUROPÄISCHE PATENTANMELDUNG

(11) **EP 4 474 144 A1**
(43) Veröffentlichungstag der Anmeldung: **11.12.2024**
(21) Anmeldenummer: 23177144.5
(22) Anmeldetag: 05.06.2023
(51) Int. Cl.: B32B 17/10, B32B 5/18, B32B 3/08, B60J 1/00, E06B 3/66, H01L 31/04, H02S 20/00

(54) **PHOTOVOLTAISCHE VERBUNDSCHEIBE MIT EVAKUIERTER AEROGEL-LAGE**

(71) Anmelder: Autoglas D & K B.V., 2404 CC Alphen aan de Rijn (NL)
(72) Erfinder: MOTEMANI SHARABIANI, Yahya, 52134 Herzogenrath (DE); MEMAR JAVID, Siyamak, 52134 Herzogenrath (DE); ZILLER, Marine, 52134 Herzogenrath (DE); ARENDT, Sebastian, 52134 Herzogenrath (DE); SCHULZ, Valentin, 52134 Herzogenrath (DE); DRIEHUIS, Bartholomeus Leonardus Marinus Borcherd, 2404 CC Alphen an den Rijn (NL)
(74) Vertreter: Patentwerk B.V.

(57) **Zusammenfassung**

Die vorliegende Erfindung betrifft eine Verbundscheibe, umfassend eine Außenscheibe (1) und eine Innenscheibe (2), die flächig miteinander verbunden sind,
wobei mindestens ein photovoltaisches Bauteil (4) zwischen der Außenscheibe (1) und der Innenscheibe (2) in die Verbundscheibe eingelagert ist
und wobei die Verbundscheibe eine Isolierungseinheit (5) aufweist, welche in der angegebenen Reihenfolge
- eine zur Außenscheibe (1) hingewandte äußere Scheibe (5a),
- eine evakuierte Aerogel-Lage (5c) und
- eine innere Scheibe (5b)
umfasst,
und wobei
(i) die Isolierungseinheit (5) zwischen der Außenscheibe (1) und der Innenscheibe (2) in die Verbundscheibe eingelagert ist und einen geringeren Abstand zur Innenscheibe (2) aufweist als das mindestens eine photovoltaische Bauteil (4) oder
(ii) die Innenscheibe (2) der Verbundscheibe die innere Scheibe (5b) der Isolierungseinheit (5) bildet.

## Beschreibung

Die Erfindung betrifft eine Verbundscheibe, die mit mindestens einem photovoltaischen Bauteil und einer Isolierungseinheit mit einer evakuierten Aerogel-Lage ausgestattet ist, sowie deren Verwendung.

Es ist allgemein bekannt, dass Verglasungen mit photovoltaischen Bauteilen ausgestattet werden können, um elektrische Energie zu gewinnen. So offenbart beispielsweise WO03028114A2 eine Isolierverglasung mit einem Photovoltaik-Modul. Isolierverglasungen werden insbesondere als Gebäudeverglasungen eingesetzt.

Bei klassischen Isolierverglasungen wird durch einen Abstandshalter ein Zwischenraum zwischen zwei Glasscheiben ausgebildet, welche mit Inertgas gefüllt ist. Um die thermische Isolierung weiter zu verbessern, sind Vakuumisolierverglasungen (VIG, *vacuum insulating glazing*) bekannt, bei denen der Scheibenzwischenraum evakuiert ist. Solche Verglasungen sind beispielsweise aus EP1978199A1 und WO9804802A1 bekannt.

Auch im Fahrzeugbereich können Verglasungen mit photovoltaischen Bauteilen interessant sein, insbesondere als Fahrzeug-Dachscheibe. Die photovoltaischen Bauteile können dabei verwendet werden beispielsweise um die Bordbatterie zu laden oder elektrische Verbraucher zu speisen. Dies gewinnt insbesondere im Zusammenhang mit Elektrofahrzeugen zunehmende Bedeutung. EP1036683A2 offenbart eine Fahrzeug-Dachscheibe, die als Einzelglasscheibe ausgebildet ist und innenraumseitig mit einem Solarzellenverbund ausgestattet ist.

Fahrzeug-Dachscheiben sind häufig als Verbundscheiben ausgebildet, umfassend eine Außenscheibe und eine Innenscheibe, die über eine thermoplastische Zwischenschicht miteinander verbunden sind. Bei solchen Verbundscheiben können die photovoltaischen Bauteile in die Zwischenschicht eingelagert werden, wie beispielsweise aus WO2013182398A1 und WO2013182399A1 bekannt ist.

Durch die photovoltaischen Bauteile kann der thermische Komfort im Fahrzeug negativ beeinflusst werden. Ein photovoltaisches Bauteil absorbiert sichtbares Licht und/oder infrarote Strahlung, um diese in elektrische Energie umzuwandeln. Dabei erwärmt sich das photovoltaische Bauteil stark, was eine zusätzliche thermische Belastung darstellt. Dadurch wird die insgesamt eingestrahlte Sonnenenergie (zusammengesetzt aus der direkt eingestrahlten Energie und der indirekt als Wärmestrahlung nach Aufheizung von Scheibenbestandteilen eingestrahlten Energie, typischerweise als TTS-Wert charakterisiert) gesteigert.

Es besteht daher Bedarf an Verbundscheiben mit photovoltaischen Bauteilen, welche einen geringen TTS-Wert aufweisen und einen hohen thermischen Komfort gewährleisten.

Aus EP3878827A1 ist eine Fahrzeugscheibe bekannt, die als Vakuumisolierverglasung ausgebildet ist.

Aerogele sind hochporöse Festkörper, welche sich bekanntermaßen durch eine sehr geringe thermische Leitfähigkeit und wärmedämmende Eigenschaften auszeichnen. Aus WO2012154602A1 ist eine Isolierverglasung mit Aerogel-Lage bekannt. Aus US2014199805A1 ist eine Solarzelle mit einer Elektrode auf Basis eines Aerogels bekannt. Aus US5221364A ist eine Solarzelle auf einem Aerogel-Substrat bekannt.

Aus CN102839893A ist eine Art Isolierverglasung bekannt, wobei zwei Glasscheiben über einen Abstandshalter miteinander verbunden sind. Der Zwischenraum ist mit Aerogel gefüllt und evakuiert.

Der vorliegenden Erfindung liegt die Aufgabe zugrunde, eine verbesserte Verbundscheibe mit mindestens einem integrierten photovoltaischen Bauteil bereitzustellen, welche einen geringen Wärmeeintrag aufweist und einen hohen thermischen Komfort gewährleistet.

Die Aufgabe wird erfindungsgemäß gelöst durch eine Verbundscheibe gemäß dem unabhängigen Anspruch 1. Vorteilhafte Ausgestaltungen gehen aus der Unteransprüchen hervor.

Die erfindungsgemäße Verbundscheibe umfasst eine Außenscheibe und eine Innenscheibe, die flächig miteinander verbunden sind. Zwischen der Außenscheibe und der Innenscheibe ist mindestens ein photovoltaisches Bauteil in die Verbundscheibe eingelagert. Die Verbundscheibe weist außerdem eine Isolierungseinheit auf.

Die Isolierungseinheit umfasst ihrerseits in der angegebenen Reihenfolge eine äußere Scheibe, eine Aerogel-Lage und eine innere Scheibe. Die Aerogel-Lage ist also zwischen der äußeren und der inneren Scheibe angeordnet. Die äußere Scheibe der Isolierungseinheit ist der Außenscheibe der Verbundscheibe zugewandt, die innere Scheibe von der Außenscheibe abgewandt. Die Aerogel-Lage ist erfindungsgemäß evakuiert, wodurch die Isolierungseinheit eine Art Vakuumisolierverglasung bildet. Die Aerogel-Lage kann alternativ auch als Aerogel-Schicht bezeichnet werden.

Die Erfindung kann grundsätzlich in zwei verschiedenen Varianten realisiert werden. In einer ersten Variante (auch als "Variante (i)" bezeichnet) ist die Isolierungseinheit zwischen der Außenscheibe und der Innenscheibe in die Verbundscheibe eingelagert, wobei die Isolierungseinheit einen geringeren Abstand zur Innenscheibe aufweist als das mindestens eine photovoltaische Bauteil. In einer zweiten Variante (auch als "Variante (ii)" bezeichnet) bildet die Innenscheibe der Verbundscheibe auch die innere Scheibe der Isolierungseinheit.

Die vorliegende Erfindung beruht auf dem Gedanken, eine Isolierungseinheit innenraumseitig zum photovoltaischen Bauteil in der Verbundscheibe vorzusehen. Die Isolierungseinheit weist eine evakuierte Aerogel-Lage zwischen zwei Scheiben auf und zeichnet sich durch gute wärmedämmende beziehungsweise thermisch isolierende Eigenschaften aus. Aufgrund dieser wärmedämmenden Eigenschaften wird der Wärmeeintrag durch die Verbundscheibe vermindert, insbesondere die innenraumseitige Emissivität der Verbundscheibe. Die Wärmestrahlung des erwärmten photovoltaischen Bauteils in Richtung der Innenscheibe wird reduziert. Die Aerogel-Lage hat außerdem akustisch-isolierende Eigenschaften, was zur Abschirmung störender äußerer Geräusche vorteilhaft ist. Sie weist nur ein sehr geringes Gewicht auf, so dass das Gesamtgewicht der Verbundscheibe nicht signifikant erhöht wird. Das sind große Vorteile der vorliegenden Erfindung.

Ein photovoltaisches Bauteil ist im Sinne der Erfindung ein einstückiges elektrisches Bauelement zur Gewinnung von elektrischer Energie beziehungsweise elektrischem Strom mittels des photovoltaischen Effekts. Das photovoltaische Bauteil wird als einzelnes Bauelement gehandhabt und verfügt bevorzugt über nur zwei elektrische Anschlüsse (zwei elektrische Pole, gleichsam "Plus- und Minus-Pol"), über welche das Bauteil als Ganzes elektrisch kontaktiert wird. Das photovoltaische Bauteil kann auch als Photovoltaikelement oder Solarelement bezeichnet werden. Eine photovoltaische Zelle ist im Sinne der Erfindung die kleinstmögliche photovoltaische Einheit, umfassend eine einzelne photovoltaisch aktive Absorberschicht zwischen einer einzelnen Frontelektrode und einer einzelnen Rückelektrode. Die photovoltaische Zelle ist strukturell nicht weiter unterteilt. Die photovoltaische Zelle kann auch als Solarzelle bezeichnet werden. Ein photovoltaisches Modul ist im Sinne der Erfindung ein einstückiges Bauelement, welches eine Mehrzahl miteinander verschalteter beziehungsweise elektrisch verbundener photovoltaischer Zellen umfasst. Die photovoltaischen Zellen können dabei seriell oder parallel verschaltet sein, oder es können Gruppen von seriell verschalteten photovoltaischen Zellen vorliegen, welche parallel verschaltet sind, oder Gruppen von parallel verschalteten photovoltaischen Zellen, welche seriell verschaltet sind. Bevorzugt ist die serielle Verschaltung sämtlicher Solarzellen. Das photovoltaische Modul kann auch als Photovoltaikmodul oder Solarmodul bezeichnet werden.

Das erfindungsgemäße mindestens eine photovoltaische Bauteil kann eine einzelne photovoltaische Zelle sein beziehungsweise umfassen oder ein photovoltaisches Modul mit einer Mehrzahl miteinander verschalteten photovoltaischen Zellen, wobei der letztgenannte Fall in der Praxis typischerweise realisiert ist.

Die Außenscheibe ist diejenige Scheibe der Verbundscheibe, welche in Einbaulage der Sonne zugewandt ist beziehungsweise dafür vorgesehen ist. Die Verbundscheibe ist typischerweise dafür vorgesehen, in einer Öffnung (insbesondere Fensteröffnung, beispielsweise einer Fensteröffnung eines Fahrzeugs oder eines Gebäudes) einen Innenraum gegenüber der äußeren Umgebung abzutrennen. Mit Innenscheibe wird im Sinne der Erfindung die dem Innenraum zugewandte Scheibe bezeichnet. Mit Außenscheibe wird die der äußeren Umgebung und der Sonne zugewandte Scheibe bezeichnet. Die Außenscheibe und die Innenscheibe weisen jeweils eine außenseitige und eine innenraumseitige Oberfläche auf und eine dazwischen verlaufende, umlaufende Seitenkantenfläche. Mit außenseitiger Oberfläche wird im Sinne der Erfindung diejenige Hauptfläche bezeichnet, welche dafür vorgesehen ist, in Einbaulage der äußeren Umgebung und der Sonne zugewandt zu sein. Mit innenraumseitiger Oberfläche wird im Sinne der Erfindung diejenige Hauptfläche bezeichnet, welche dafür vorgesehen ist, in Einbaulage dem Innenraum zugewandt zu sein. Die innenraumseitige Oberfläche der Außenscheibe und die außenseitige Oberfläche der Innenscheibe sind einander zugewandt und miteinander verbunden.

Die äußere Scheibe der Isolierungseinheit ist in Einbaulage ebenfalls der äußeren Umgebung und der Außenscheibe zugewandt. Die innere Scheibe der Isolierungseinheit ist dem Innenraum zugewandt sowie in Variante (i) der Innenscheibe.

Die erfindungsgemäße Verbundscheibe ist bevorzugt eine Fahrzeugscheibe (Fensterscheibe eines Fahrzeugs) oder Gebäudeverglasung, ganz besonders bevorzugt eine Fahrzeug-Dachscheibe.

Die Außenscheibe ist über eine Zwischenschicht mit der Isolierungseinheit verbunden. Das mindestens eine photovoltaische Bauteil ist in diese Zwischenschicht eingelagert, wobei es zwischen der Außenscheibe und der Innenscheibe angeordnet ist. Die Isolierungseinheit ist innenraumseitig des mindestens einen photovoltaischen Bauteils angeordnet, weist also einen größeren Abstand zur Außenscheibe auf als das mindestens eine photovoltaische Bauteil. Umgekehrt ist das mindestens eine photovoltaische Bauteil außenseitig der Isolierungseinheit angeordnet, weist also einen geringeren Abstand zur Außenscheibe (und in Einbaulage der äußeren Umgebung) auf als die Isolierungseinheit. Betrachtet in Draufsicht auf die Verbundscheibe überlappt die Isolierungseinheit das mindestens eine photovoltaische Bauteil bevorzugt vollständig, das mindestens eine photovoltaische Bauteil ist also vollständig innerhalb des von der Seitenkante der Isolierungseinheit begrenzten Bereichs angeordnet und steht nicht über die Isolierungseinheit über. Mit dem Ausdruck "mindestens ein photovoltaisches Bauteil" ist dabei die Gesamtheit aller vorhandenen photovoltaischen Bauteile gemeint.

Die Verbundscheibe kann ein einzelnes photovoltaisches Bauteil enthalten oder eine Mehrzahl photovoltaischer Bauteile. Weist sie eine Mehrzahl photovoltaischer Bauteile auf, so sind bevorzugt sämtliche photovoltaische Bauteile in derselben Ebene beziehungsweise Lage der Verbundscheibe angeordnet. Sämtliche photovoltaische Bauteile weisen dann (zumindest näherungsweise) denselben Abstand zur Außenscheibe beziehungsweise zur Innenscheibe auf. Aber selbst wenn die photovoltaischen Bauteile in unterschiedlichen Ebenen beziehungsweise Lagen der Verbundscheibe angeordnet sein sollten, so ist doch die Isolierungseinheit bevorzugt innenraumseitig sämtlicher photovoltaischer Bauteile angeordnet mit einem größeren Abstand zur Außenscheibe.

Die Verbundscheibe kann grundsätzlich auch mehrere Isolierungseinheiten aufweisen, wobei bevorzugt sämtliche Isolierungseinheiten innenraumseitig des mindestens einen photovoltaischen Bauteils angeordnet sind mit einem größeren Abstand zur Außenscheibe. Bevorzugt ist jedoch eine einzelne Isolierungseinheit aufgrund eines einfacheren Aufbaus und einer einfacheren Herstellung der Verbundscheibe.

In einer bevorzugten Ausgestaltung ist das mindestens eine photovoltaische Bauteil über jeweils eine thermoplastische Lage mit der Außenscheibe und der Isolierungseinheit verbunden. Bei Variante (i) ist die Isolierungseinheit in einer bevorzugten Ausgestaltung über eine thermoplastische Lage mit der Innenscheibe verbunden.

Bei Variante (i) der Erfindung umfasst die Verbundscheibe in der angegebenen Reihenfolge in einer bevorzugten Ausgestaltung:
- die Außenscheibe,
- eine erste thermoplastische Lage,
- das mindestens eine photovoltaische Bauteil,
- eine zweite thermoplastische Lage,
- die Isolierungseinheit,
- eine dritte thermoplastische Lage und
- die Innenscheibe.

In Variante (i) sind die Außenscheibe und die Innenscheibe über eine Zwischenschicht miteinander verbunden, wobei sowohl das mindestens eine photovoltaische Bauteil als auch die Isolierungseinheit in die Zwischenschicht eingelagert sind.

Bei Variante (ii) der Erfindung umfasst die Verbundscheibe in der angegebenen Reihenfolge in einer bevorzugten Ausgestaltung:
- die Außenscheibe,
- eine erste thermoplastische Lage,
- das mindestens eine photovoltaische Bauteil,
- eine zweite thermoplastische Lage,
- die Isolierungseinheit.

In Variante (ii) ist die Isolierungseinheit ein exponiertes Element der Verbundscheibe, wobei die exponierte innere Scheibe der Isolierungseinheit auch die Innenscheibe der Verbundscheibe bildet. Innenscheibe und innere Scheibe sind also identisch. Die Außenscheibe und die Isolierungseinheit sind über eine Zwischenschicht miteinander verbunden, wobei das mindestens eine photovoltaische Bauteil in die Zwischenschicht eingelagert ist.

In besonders bevorzugten Ausgestaltungen der vorstehend beschriebenen bevorzugten Konfigurationen besteht die Verbundscheibe strukturell jeweils nur aus den angegebenen Elementen. Die Außenscheibe, die Innenscheibe, die thermoplastischen Lage und/oder die Scheiben der Isolierungseinheit können darüber hinaus mit fachüblichen Beschichtungen oder Aufdrucken ausgestattet sein.

In allen Ausgestaltungen sind die Außenscheibe und die erste thermoplastische Lage bevorzugt klar und weisen keine Tönungen oder Färbungen auf, um das Sonnenlicht nicht abzuschwächen, bevor es auf das mindestens eine photovoltaische Bauteil trifft. Die zweite thermoplastische Lage, die Isolierungseinheit, die Innenscheibe und, sofern vorhanden, die dritte thermoplastische Lage können unabhängig voneinander klar oder getönt oder gefärbt sein.

Die thermoplastischen Lagen können alternativ auch als thermoplastische Schichten bezeichnet werden. Sie haben die Aufgabe, die Bestandteile der Verbundscheibe, zwischen denen sie angeordnet sind, adhäsiv miteinander zu verbinden.

Die thermoplastischen Lagen sind bevorzugt auf Basis von Polyvinylbutyral (PVB), Ethylen-Vinylacetat (EVA) oder Polyurethan (PU) ausgebildet oder aus Gemischen oder Copolymeren oder Derivaten davon, besonders bevorzugt auf Basis von PVB. Damit ist gemeint, dass die Lage größtenteils das besagte Polymer enthält (Anteil größer als 50 Gew.-%). Die Lage kann außer dem Polymer weitere Zusätze enthalten, beispielsweise Weichmacher, UV-Absorber oder Stabilisatoren. Jede thermoplastische Lage ist bevorzugt aus mindestens einer thermoplastischen Folie ausgebildet. Die Dicke jeder Folie beträgt bevorzugt von 0,2 mm bis 1 mm. Beispielsweise können PVB-Folien mit den Standarddicken von 0,38 mm oder 0,76 mm verwendet werden.

Statt thermoplastischer Lagen können prinzipiell auch andersartige Verbindungsschichten eingesetzt werden, beispielsweise Gießharzschichten oder Klebstoffschichten, insbesondere Schichten optisch klarer Klebstoffe (*optically clear adhesives*, OCA).

Die Außenscheibe und die Innenscheibe sind bevorzugt Glasscheiben, besonders bevorzugt gefertigt aus Kalk-Natron-Glas, wie es für Fensterscheiben üblich ist. Eine oder beide der Scheiben können grundsätzlich aber auch aus anderen Glassorten gefertigt sein, beispielsweise Quarzglas, Borosilikatglas oder Aluminosilikatglas, oder aus starren klaren Kunststoffen, beispielsweise Polycarbonat oder Polymethylmethacrylat. Die Dicken der Außenscheibe und der Innenscheibe betragen unabhängig voneinander bevorzugt von 0,5 mm bis 5 mm, besonders bevorzugt von 1 mm bis 3 mm.

Die Außenscheibe und die Innenscheibe können optional unabhängig voneinander thermisch oder chemisch vorgespannt, teilvorgespannt oder nicht vorgespannt sein. Eine Vorspannung ist aber grundsätzlich nicht nötig, weil alle Schichten der Verbundscheibe typischerweise vollflächig nach Art eines Verbundsicherheitsglases miteinander verbunden sind (die Scheiben der Isolierungseinheit durch die Aerogel-Lage).

Die Verbundscheibe ist erfindungsgemäß mit einer Isolierungseinheit ausgestattet. Die Isolierungseinheit umfasst eine äußere Scheibe und eine innere Scheibe, zwischen denen eine Aerogel-Lage angeordnet ist, welche evakuiert ist.

In Variante (i) weisen die äußere Scheibe und die innere Scheibe eine Dicke von beispielsweise 0,3 mm bis 5 mm auf, bevorzugt von 0,3 mm bis 3 mm, besonders bevorzugt von 0,5 mm bis 2 mm, ganz besonders bevorzugt von 0,5 mm bis 1,5 mm, insbesondere von 0,5 mm bis 1 mm. Die äußere und die innere Scheibe sind bevorzugt dünner ausgebildet als die Außenscheibe und die Innenscheibe.

In Variante (ii) weist die äußere Scheibe eine Dicke von beispielsweise 0,3 mm bis 5 mm auf, bevorzugt von 0,3 mm bis 3 mm, besonders bevorzugt von 0,5 mm bis 2 mm, ganz besonders bevorzugt von 0,5 mm bis 1,5 mm, insbesondere von 0,5 mm bis 1 mm. Die innere Scheibe ist identisch mit der Innenscheibe der Verbundscheibe und es gelten die vorstehend für die Innenscheibe angegebenen bevorzugten Dicken.

Die äußere Scheibe und die innere Scheibe sind bevorzugt aus Glas gefertigt. Es kann ebenfalls Kalk-Natron-Glas eingesetzt werden. Insbesondere sehr dünne äußere und innere Scheiben (beispielsweise mit Dicken von 0,5 mm bis 1 mm) können auch aus Aluminosilikatglas ausgebildet sein, welches bevorzugt chemisch vorgespannt ist. Die äußere und innere Scheibe sind bevorzugt transparent.

Die Aerogel-Lage ist erfindungsgemäß evakuiert, um die thermische Isolationswirkung des Aerogels zu steigern. Die Isolierungseinheit stellt daher eine Art Vakuumisolierverglasung dar.

Damit ist gemeint, dass im Zwischenraum zwischen der äußeren und der inneren Scheibe, in dem die Aerogel-Lage angeordnet ist, ein Unterdruck herrscht, also ein Druck, welcher geringer ist als der Umgebungsdruck. Der Druck im Zwischenraum beträgt bevorzugt höchstens 100 mbar, besonders bevorzugt höchstens 10 mbar. Der Druck kann beispielsweise von 0,01 mbar bis 100 mbar betragen, bevorzugt von 0,1 mbar bis 10 mbar.

Die Isolierungseinheit weist bevorzugt eine gasdichte Randversiegelung auf, um den Unterdruck aufrecht zu erhalten. Die Randversiegelung schließt den Zwischenraum zwischen der äußeren und der inneren Scheibe, in dem die Aerogel-Lage angeordnet ist, gegenüber der Umgebung gasdicht ab. Die Randversiegelung kann beispielsweise aus Glas, einem Metall oder einer Metalllegierung (beispielsweise rostfreiem Stahl, Silber oder Kupfer) oder einem gasdichten Kunststoff ausgebildet sein.

Die Aerogel-Lage ist bevorzugt über jeweils eine haftvermittelnde Schicht mit der äußeren Scheibe und der inneren Scheibe der Isolierungseinheit verbunden. Die haftvermittelnden Schichten können beispielsweise als Klebstoffschichten ausgebildet sein, besonders bevorzugt als Schichten eines optisch klaren Klebstoffs. Die haftvermittelnden Schichten können alternativ als thermoplastische Lagen ausgebildet sein. Die thermoplastischen Lagen sind bevorzugt aus jeweils einer thermoplastischen Folie ausgebildet, besonders bevorzugt auf Basis von Polyvinylbutyral (PVB), Ethylen-Vinylacetat (EVA) oder Polyurethan (PU), ganz besonders bevorzugt mit einer Dicke von 0,2 mm bis 1 mm, insbesondere von 0,2 mm bis 0,5 mm.

Es ist auch denkbar, dass das Aerogel direkt auf einer der Scheiben erzeugt wird und mit der anderen Scheibe über einer haftvermittelnde Schicht verbunden wird. Ebenfalls ist denkbar, dass die äußere und die innere Scheibe beispielsweise durch einen umlaufenden peripheren Abstandshalter miteinander verbunden sind und auf Abstand gehalten werden und die Aerogel-Lage im Zwischenraum angeordnet ist, ohne mit den Scheiben adhäsiv verbunden zu sein.

Die Dicke der Aerogel-Lage kann den Erfordernissen des konkreten Anwendungsfalls entsprechend gewählt werden. Dabei spielen insbesondere die Wärmeleitfähigkeit des Aerogels (welche wiederum vom Material, Dichte und Porosität abhängig ist), die Wärmeaufnahme des mindestens einen photovoltaischen Bauteils (welche wiederum von Art des Bauteils und der Flächenabdeckung abhängig ist) und der erwünschte Wärmeeintrag (also der gewünschte TTS-Wert, die insgesamt eingestrahlte Sonnenenergie) eine Rolle. Bevorzugt weist die Aerogel-Lage eine Dicke im Bereich von 0,1 mm bis 10 mm auf, besonders bevorzugt von 0,2 mm bis 8 mm, ganz bevorzugt von 0,5 mm bis 6 mm oder von 0,5 mm bis 5 mm. Damit werden bei typischen Anwendungen gute Ergebnisse erzielt. Ganz besonders bevorzugt weist die Aerogel-Lage eine Dicke von 1 mm bis 4 mm auf. Bei typischen Anwendungen wird bereits mit einer solch geringen Dicke der Aerogel-Lage eine gute thermische Isolierung erreicht, weil durch die Evakuierung die thermische Isolierung weiter verbessert wird. Dadurch können Verbundscheiben mit vorteilhaft dünnen Aerogel-Lagen realisiert werden.

Anders als der Name zunächst vermuten lässt sind Aerogele keine Gele, sondern hochporöse Festkörper. Der Name rührt daher, dass Aerogele typischerweise aus Gelen hergestellt werden, wobei die flüssige Komponente des Gels durch ein Gas ersetzt wird, ohne dass die Gelstruktur kollabiert, beispielsweise durch superkritische Trocknung oder Gefriertrocknung. Aerogele bestehen strukturell aus einer Verästelung von Partikelketten (dendritische Struktur) mit sehr vielen Zwischenräumen (Poren), insbesondere in Form offener Poren. Die Partikelketten weisen Kontaktstellen zueinander auf, so dass das Aerogel als stabiles, schwammartiges Netz aufgefasst werden kann. Die Partikelketten selbst ergeben sich häufig durch die Fusion von beispielsweise sphärischen Partikeln. Ein sehr hoher Volumenanteil der Aerogele besteht aus Poren, insbesondere offenen Poren. Daher weisen Aerogele eine sehr geringe Dichte auf. Die erfindungsgemäße Aerogel-Lage hat daher ein geringes Gewicht, so dass das Gewicht der Verbundscheibe selbst durch vergleichsweise dicke Aerogel-Lagen nicht wesentlich erhöht wird. Aerogele können darüber hinaus eine hohe optische Transparenz aufweisen, was für Anwendungen in Verglasungen besonders vorteilhaft sein kann. Aerogele können beispielsweise durch Sol-Gel-Verfahren hergestellt werden.

Es können Einlagerungen in den Poren vorhanden, beispielsweise um die mechanischen, thermischen oder optischen Eigenschaften der Aerogel-Lage zu beeinflussen. Die Poren sind typischerweise luftgefüllt (entsprechend des in der Isolierungseinheit herrschenden Unterdrucks), abgesehen von etwaigen Einlagerungen. Die erfindungsgemäße Aerogel-Lage kann auch als Lage oder Schicht aus einem Aerogel oder auf Basis eines Aerogels bezeichnet werden.

Unter der Porosität wird im Sinne der Erfindung der Anteil des Volumens der Poren am Gesamtvolumen des Aerogels bezeichnet. Die erfindungsgemäße Aerogel-Lage ist bevorzugt aus einem Aerogel beziehungsweise auf Basis eines Aerogels ausgebildet, welches eine Porosität von 50% bis 99,98% aufweist, besonders bevorzugt von 80% bis 99%, ganz besonders bevorzugt von 85% bis 98%. Die Porosität kann durch Gasabsorption bestimmt werden.

Die Porengröße des Aerogels beträgt bevorzugt von 1 nm bis 50 nm, besonders bevorzugt von 10 nm bis 40 nm. Damit ist insbesondere der Durchmesser der typischerweise näherungsweise kugelförmigen Poren gemeint.

Die Dichte des Aerogels beträgt bevorzugt von 0,16 mg/cm³ bis 500 mg/cm³, besonders bevorzugt von 10 mg/cm³ bis 300 mg/cm³. Damit ist die Rohdichte gemeint basierend auf dem Volumen einschließlich der Porenräume, wobei die Luft in den Poren nicht in die Masse eingerechnet wird.

Die Partikel, welches das Netzwerk an Partikelketten aufbauen, weisen typischerweise eine Größe von 1 nm bis 10 nm auf.

Aerogele können aus verschiedenen Materialien gebildet werden (Material der Partikelketten). Das Aerogel der erfindungsgemäßen Aerogel-Lage ist bevorzugt aus Silikat, aus einem Polymer, aus Kohlenstoff, aus Cellulose oder aus einem Metalloxid ausgebildet. Grundsätzlich sind sämtliche Polymere und Metalloxide geeignet. Beispiele sind Polyimid für ein Polymer und Aluminiumoxid, Titanoxid, Zirkoniumoxid (alle transparent und weiß oder bläulich), Eisenoxid (opak, rot oder gelb), Chromoxid (opak, grün oder blau) und Vanadiumoxid (opak, olivgrün) für Metalloxide. Silikat-Aerosole besitzen streng genommen nicht die chemische Zusammensetzung eines Silikats, sondern etwa SiO(OH)_{y}(OR)_{z}, wobei R ein organischer Rest ist und die Parameter y und z vom Herstellungsprozess abhängig sind. Sie werden dennoch allgemein derart bezeichnet und der Ausdruck Silikat auch im Rahmen der vorliegenden Erfindung entsprechend benutzt. Im Englischen ist auch die Bezeichnung "silica aerogel" gebräuchlich (also SiO₂-Aerogel). Für die erfindungsgemäße Aerogel-Lage sind Silikat-Aerogele und Polymer-Aerogele besonders bevorzugt. Diese Aerogele sind gut erforscht und bereits in großer Zahl kommerziell erhältlich.

Die erfindungsgemäße Aerogel-Lage kann strukturell unterschiedlich ausgebildet sein und in die Verbundscheibe integriert werden, insbesondere
- als sogenanntes Blanket ("Decke"); darunter wird ein Verbundwerkstoff verstanden aus einem Aerogel (insbesondere Silikat-Aerogel) mit Einlagerungen, welche die mechanischen Eigenschaften beeinflussen (insbesondere Glasfasern); Blankets sind flexibel und können beispielsweise auf Rollen bereitgestellt werden;
- als Filz (insbesondere Silikat-Aerogel-Filz); Filze sind flexibel und können ebenfalls beispielsweise auf Rollen bereitgestellt werden;
- als Folie; Folien sind flexibel und können ebenfalls beispielsweise auf Rollen bereitgestellt werden; sie sind typischerweise aus einem oder auf Basis eines Polymer-Aerogels ausgebildet, welches optional Einlagerungen aufweisen kann;
- als starre Schicht ("Platte");
- in Form von Granulat (mit Partikelgrößen beispielsweise im Millimeter-Bereich) oder Partikeln (mit Partikelgrößen beispielsweise im Mikrometer-Bereich).

Da die Aerogel-Lage akustisch dämpfende Eigenschaften aufweist, kann auch die Verwendung sogenannter akustischer thermoplastischer Folien verzichtet werden. Stattdessen werden bevorzugt einlagige Folien als thermoplastische Lagen verwenden.

Die Außenscheibe weist (mindestens) einen transparenten Bereich auf, der im Sinne der Erfindung als Durchsichtsbereich bezeichnet wird. Im transparenten Durchsichtsbereich kann Sonnenlicht durch die Außenscheibe hindurchtreten und das mindestens eine photovoltaische Bauteil anregen. Der transparente Durchsichtsbereich der Außenscheibe definiert daher einen aktiven Bereich der Verbundscheibe. Damit ist gemeint, dass in Draufsicht auf die Verbundscheibe der transparente Bereich der Außenscheibe und der aktive Bereich deckungsgleich sind. Das mindestens eine photovoltaische Bauteil ist (zumindest teilweise, insbesondere größtenteils oder sogar vollständig) im Durchsichtsbereich angeordnet.

Die Außenscheibe kann insgesamt transparent ausgebildet sein, so dass der Durchsichtsbereich die gesamte Außenscheibe umfasst. Dann bildet die gesamte Verbundscheibe den aktiven Bereich. Die Außenscheibe kann aber auch einen opaken Maskierungsbereich aufweisen, durch den kein Sonnenlicht treten kann und der einen Maskierungsbereich der Verbundscheibe definiert. Der aktive Bereich entspricht dann der Verbundscheibe abzüglich des Maskierungsbereichs. Solche Maskierungsbereiche sind insbesondere bei Fahrzeugscheiben üblich. Sie werden typischerweise durch einen opaken Abdeckdruck auf der innenraumseitigen Oberfläche der Außenscheibe ausgebildet. Dabei wird eine Emaille-Druckpaste, welche Glasfritten und ein Pigment, insbesondere Schwarzpigment, enthält, beispielsweise im Siebdruckverfahren auf die Oberfläche aufgedruckt und anschließend eingebrannt. Der Maskierungsbereich umfasst typischerweise einen umlaufenden Randbereich der Außenscheibe, der einen zentralen Durchsichtsbereich rahmenartig umgibt. Der Maskierungsbereich kann aber auch weitere Bereiche umfassen, welche beispielsweise als eine Art von Querverstrebungen des rahmenartigen Randbereichs ausgebildet sind.

Ein Maskierungsbereich kann alternativ auch dadurch ausgebildet sein, dass eine zwischen dem mindestens einen photovoltaischen Bauteil und der Außenscheibe befindliche thermoplastische Lage opak ausgebildet ist oder eine opake Folie oder Platte zwischen dem mindestens einen photovoltaischen Bauteil und der Außenscheibe in die Verbundscheibe eingelagert ist. Auch dann kann im Maskierungsbereich kein Sonnenlicht auf das photovoltaische Bauteil treffen. In diesem Falle wird der aktive Bereich der Verbundscheibe ebenfalls verkleinert, obwohl die Außenscheibe insgesamt transparent ausgebildet ist. Das vorstehend Ausgeführte gilt entsprechend.

Das mindestens eine photovoltaische Bauteil kann sich vom aktiven Bereich in den Maskierungsbereich hinein erstrecken. Die dort angeordneten Bereiche tragen dann zwar nicht zur Stromgewinnung bei, es kann aber aus ästhetischen Gründen gewünscht sein.

Die erfindungsgemäße Isolierungseinheit deckt bevorzugt zumindest den aktiven Bereich der Verbundscheibe vollständig ab. Sie kann die gesamte Verbundscheibe abdecken und sich bis zu ihren Seitenkanten erstrecken. Weist die Verbundscheibe aber einen Maskierungsbereich auf, in dem keine photovoltaischen Bauteile vorhanden sind, so muss dort keine Isolierungseinheit vorgesehen sein. Es ist beispielsweise möglich, dass die Isolierungseinheit in einem Ausschnitt einer thermoplastischen Lage angeordnet ist, von der sie rahmenartig umgeben wird, wobei die rahmenartige thermoplastische Lage bevorzugt in einem umlaufenden peripheren Maskierungsbereich angeordnet ist.

Es können opake oder transparente photovoltaische Bauteile verwendet werden. Opake photovoltaische Bauteile können dadurch realisiert werden, dass das photovoltaisch aktive Material (Absorberschicht) im sichtbaren Spektralbereich absorbiert und/oder dass eine opake Rückelektrode eingesetzt wird. Transparente photovoltaische Bauteile können dadurch realisiert werden, dass das photovoltaisch aktive Material vollständig oder zumindest größtenteils im infraroten Spektralbereich absorbiert (und zumindest in einem Großteil des sichtbaren Spektralbereichs nicht absorbiert) und dass transparente Elektroden eingesetzt werden.

In einer ersten Ausgestaltung der erfindungsgemäßen Verbundscheibe ist das mindestens eine photovoltaische Bauteil opak und deckt den aktiven Bereich vollständig ab. Die Verbundscheibe ist dann insgesamt opak. Dies kann realisiert werden, indem ein einzelnes photovoltaisches Bauteil eingesetzt wird, welche den aktiven Bereich vollständig abdeckt. Alternativ kann dies dadurch realisiert werden, dass eine Mehrzahl photovoltaischer Bauteile eingesetzt werden, wobei benachbarte photovoltaische Bauteile bündig aneinander gesetzt sind ober überlappend angeordnet sind. Die Aerogel-Lage der Isolierungseinheit kann in diesem Fall transparent, transluzent oder opak sein.

In einer zweiten Ausgestaltung der erfindungsgemäßen Verbundscheibe ist das mindestens eine photovoltaische Bauteil opak und deckt nur einen Teil des aktiven Bereichs ab. Bevorzugt ist dabei eine Mehrzahl photovoltaischer Bauteile im aktiven Bereich vorhanden. Es kann eine Mehrzahl voneinander beabstandeter, opaker photovoltaischer Bauteile im aktiven Bereich vorhanden sein. Alternativ können mehrere Gruppen photovoltaischer Bauteile vorhanden sein, wobei die Bauteile jeder Gruppe bündig aneinander gesetzt sind oder einander überlappen, so dass jede Gruppe eine geschlossene Fläche abdeckt, und die Gruppen voneinander beabstandet sind. In jedem Fall ist nur ein Teil des aktiven Bereichs mit photovoltaischen Bauteilen belegt beziehungsweise abgedeckt, während ein anderer Teil des aktiven Bereichs nicht mit photovoltaischen Bauteilen belegt ist. Anders ausgedrückt ist das mindestens eine photovoltaische Bauteil (beziehungsweise die Mehrzahl photovoltaischer Bauteile) opak und deckt den aktiven Bereich nur teilweise ab. Die Verbundscheibe ist dann teil-opak und teil-transparent, womit gemeint ist, dass sie opake und transparente Bereich aufweist. Die Größe der photovoltaischen Bauteile und die Abstände können im Anwendungsfall frei gewählt werden, um den Bedeckungsgrad des aktiven Bereichs mit photovoltaischen Bauteilen wie gewünscht einzustellen. Die Aerogel-Lage der Isolierungseinheit ist in diesem Fall bevorzugt transparent oder transluzent, damit Licht durch die nicht mit photovoltaischen Bauteilen versehenen Bereiche hindurchtreten kann. Bei einer transluzenten Aerogel-Lage sind die vorgenannten transparenten Bereich natürlich streng genommen nicht transparent, sondern transluzent.

In einer dritten Ausgestaltung der erfindungsgemäßen Verbundscheibe ist das mindestens eine photovoltaische Bauteil transparent. Es deckt den aktiven Bereich bevorzugt vollständig ab, um eine optimale Energieausbeute zu gewährleisten. Dies kann wiederum realisiert werden, indem ein einzelnes photovoltaisches Bauteil eingesetzt wird, welches den aktiven Bereich vollständig abdeckt, oder dass eine Mehrzahl bündig aneinander gesetzter oder überlappender photovoltaischer Bauteile eingesetzt wird. Alternativ ist es aber grundsätzlich auch möglich, dass eine Mehrzahl voneinander beabstandeter photovoltaischer Bauteile (oder eine Mehrzahl voneinander beanstandeter Gruppen von photovoltaischen Bauteilen) im aktiven Bereich vorhanden ist. Die Aerogel-Lage der Isolierungseinheit ist in diesem Fall bevorzugt transparent oder transluzent, damit Licht durch den aktiven Bereich der Verbundscheibe hindurchtreten kann. Der aktive Bereich ist dann insgesamt transparent beziehungsweise transluzent.

Unter einer opaken Aerogel-Lage wird eine solche Lage verstanden, durch die keine Durchsicht möglich ist. Eine opake Aerogel-Lage weist bevorzugt eine Lichttransmission von weniger als 5%, besonders bevorzugt weniger als 2%, insbesondere 0% auf. Unter einer transparenten Aerogel-Lage wird eine solche Lage verstanden, durch die eine Durchsicht möglich ist, so dass der Betrachter dahinter befindliche Objekte erkennen kann. Die Aerogel-Lage kann aber durchaus getönt sein, um die Lichttransmission zu verringern. Eine transparente Aerogel-Lage weist bevorzugt eine Lichttransmission von mehr als 10%, besonders bevorzugt mehr als 50%, insbesondere mehr als 70% auf. Unter einer transluzenten Aerogel-Lage wird eine solche Lage verstanden, durch die zwar Licht hindurchtritt, welches dabei aber stark gestreut wird, so dass der Betrachter dahinter befindliche Objekte nicht klar (höchstens schemenhaft) erkennen kann.

Das mindestens eine photovoltaische Bauteil ist geeignet, Sonnenlicht direkt in elektrische Energie umzuwandeln. Dazu weist das photovoltaische Bauteil eine photovoltaisch aktive Absorberschicht auf zwischen einer Frontelektrode und einer Rückelektrode (streng genommen weist jede photovoltaische Zelle eine eigene, separate Absorberschicht und eigene, separate Elektroden auf, wenn das Bauteil als Solarmodul mehrere verschaltete photovoltaische Zellen umfasst). Die Frontelektrode ist dabei der Außenscheibe der Verbundscheibe zugewandt, die Rückelektrode der Innenscheibe. Die Elektroden sind insbesondere Flächenelektroden, welche die gesamte Absorberschicht abdecken. Wird Sonnenlicht absorbiert, so werden in der Absorberschicht freie Ladungsträger erzeugt (photovoltaischer Effekt als Sonderfall des inneren photoelektrischen Effekts), welche über die Elektroden zur Gewinnung elektrischer Energie beziehungsweise eines elektrischen Stroms abgeführt werden. Die Absorberschicht enthält häufig Dotierungen, um den Transport der Ladungsträger zu den Elektroden zu optimieren.

Im Rahmen der vorliegenden Erfindung können im Prinzip sämtliche Arten von photovoltaischen Bauteilen beziehungsweise Zellen verwendet werden. Es liegen keine Einschränkungen auf bestimmte photovoltaische Zellen vor. Insbesondere:
- können Dünnschichtzellen oder Dickschichtzellen verwendet werden; bei einer Dünnschichtzelle liegt die Absorberschicht als dünne Schicht mit einer Dicke von beispielsweise 0,5 µm bis 3 µm; bei Dickschichtzellen weist die Absorberschicht eine größere Dicke auf (beispielsweise 20 µm bis 500 µm);
- kann jedes beliebige photovoltaisch aktive Material für die Absorberschicht verwendet werden, beispielsweise anorganische Halbleiter (wie Silizium, Cadmiumtellurid, Galliumarsenid, Indiumgalliumarsenid, Indiumgalliumphosphid, CI(G)S-Chalkopyrithalbleiter oder auch Kombinationen davon) oder organische konjugierte Polymer, organische konjugierte Oligomere oder organische Farbstoffe;
- kann die Kristallstruktur der Absorberschicht mono kristallin, polykristallin oder amorph sein.

Dickschichtzellen können beispielsweise eine Absorberschicht auf Basis von monokristallinem oder polykristallinem Silizium aufweisen. Dünnschichtzellen können beispielsweise eine Absorberschicht auf Basis von amorphem oder polykristallinem (insbesondere mikrokristallinem) Silizium, auf Basis von Galliumarsenid, auf Basis von Cadmiumtellurid oder auf Basis von organischen konjugierten Polymeren aufweisen. Dünnschichtzellen können auch einen Chalkopyrithalbleiter wie eine Verbindung der Gruppe Kupfer-Indium-Schwefel/Selen (CIS; beispielsweise CuInSe₂) oder eine Verbindung der Gruppe Kupfer-Indium-Gallium-Schwefel/Selen (CIGS; beispielsweise Cu(InGa)(SSe)₂) aufweisen.

Dünnschichtzellen sind im Rahmen der vorliegenden Erfindung bevorzugt, weil sie typischerweise flexibel sind und sich somit an eine gebogene Form der Verbundscheibe anpassen können, wie sie insbesondere bei Fahrzeugscheiben üblich ist.

Die Frontelektrode und die Rückelektrode können beispielsweise als dünne leitende oder halbleitende Schichten ausgebildet sein mit Dicken von bevorzugt von 50 nm bis 2 µm. Die Schichten können dabei beispielsweise Metalle wie Silber, Gold, Kupfer, Molybdän, Titan, Wolfram, Nickel, Titan, Chrom, Tantal, Aluminium-dotiertes Zinkoxid oder transparente leitfähige Oxide wie Indium-Zinnoxid enthalten. Die Frontelektrode und/oder die Rückelektrode können aber auch beispielsweise als Geflecht dünner Drähte, welche beispielsweise Aluminium, Kupfer, Silber und / oder Gold enthalten, ausgebildet sein. Zumindest die Frontelektrode ist transparent, damit das Sonnenlicht in die Absorberschicht eindringen kann. Die Elektroden können als einzelne Schichten oder als Stapel mehrerer Schichten ausgebildet sein.

Das photovoltaische Bauteil kann außer der Absorberschicht und den Elektroden natürlich weitere Einzelschichten umfassen, die dem Fachmann bekannt sind, beispielsweise eine Pufferschicht zur Anpassung der elektronischen Eigenschaften zwischen der Absorberschicht und einer Elektrodenschicht oder Diffusionssperrschichten.

Es können auch folienartige photovoltaische Bauteile verwendet werden. Bei einem folienartigen photovoltaischen Bauteil sind die Elektroden und die Absorberschicht auf eine Trägerfolie unabhängig voneinander aufgedruckt, nasschemisch aufgebracht oder aus der Gasphase abgeschieden. Sie umfassen typischerweise photovoltaische Dünnschichtzellen. Folienartige photovoltaische Bauteile können auf Rollen bereitgestellt werden und sehr einfach verarbeitet und in die Verbundscheibe integriert werden, was sie besonders vorteilhaft macht. Außerdem sind sie flexibel und passen sich leicht an eine gebogene Form der Verbundscheibe an. Die Trägerfolie kann beispielsweise aus oder auf Basis von Polyethylenterephthalat (PET), Polypropylen, Polyvinylchlorid, fluorinierte Ethylen-Propylene, Polyvinylfluorid oder Ethylen-Tetrafluorethylen ausgebildet sein. Die Dicke der Trägerfolie beträgt beispielsweise von 10 µm bis 300 µm.

Das mindestens eine photovoltaische Bauteil kann optional von einer weiteren thermoplastischen Lage umgeben sein, welche im Sinne der Erfindung auch als Kapsellage bezeichnet wird. Die Kapsellage ist insbesondere rahmenartig ausgebildet und in einem umlaufenden Randbereich der Verbundscheibe angeordnet, wobei das mindestens eine photovoltaische Bauteil gleichsam in die rahmenartige Kapselschicht eingesetzt ist. Die Kapsellage weist mindestens eine Aussparung auf, in welche das mindestens eine photovoltaische Bauteil eingesetzt ist. Die Kapsellage kann durch eine thermoplastische Folie (oder mehrere übereinander gestapelte thermoplastische Folien) gebildet werden, in welche die Aussparung durch Ausschneiden eingebracht worden ist. Alternativ kann die Kapsellage auch aus mehreren Folienabschnitten um das mindestens eine photovoltaische Bauteil zusammengesetzt sein. Die Kapsellage weist bevorzugt etwa die gleiche Dicke auf wie das mindestens eine photovoltaische Bauteil. Dadurch wird der lokale Dickenunterschied, der durch das örtlich begrenzte mindestens eine photovoltaische Bauteil eingebracht wird, kompensiert, so dass Lufteinschlüsse vermieden werden, Glasbruch beim Laminieren vermieden werden kann und ein verbessertes optisches Erscheinungsbild entsteht. Sind mehrere photovoltaische Bauteile vorhanden, welche den aktiven Bereich der Verbundscheibe nur teilweise abdecken, so ist die Kapsellage bevorzugt auch in den nicht mit photovoltaischen Bauteilen versehenen Bereichen angeordnet.

Die von der Außenscheibe abgewandte, innenraumseitige Oberfläche der Innenscheibe ist bevorzugt mit einer emissivitätsmindernden Beschichtung versehen. Emissivitätsmindernde Beschichtungen sind auch als Wärmestrahlung reflektierende Beschichtungen, Beschichtungen niedriger Emissivität oder LowE-Beschichtungen (*low emissivity*) bekannt. Mit Emissivität wird das Maß bezeichnet, welches angibt, wie viel Wärmestrahlung die Scheibe in Einbaulage im Vergleich zu einem idealen Wärmestrahler (einem schwarzen Körper) in einen Innenraum abgibt. Emissivitätsmindernde Beschichtungen haben die Funktion, die Einstrahlung von Wärme in den Innenraum zu vermeiden (IR-Anteile der Sonnenstrahlung und insbesondere die thermische Strahlung der Scheibe selbst) und ebenso die Abstrahlung von Wärme aus dem Innenraum heraus. Sie weisen reflektierende Eigenschaften gegenüber infraroter Strahlung auf, insbesondere gegenüber Wärmestrahlung im Spektralbereich von 5 µm - 50 µm (vgl. auch Norm DIN EN 12898:2019-06). Dadurch wird der thermische Komfort im Innenraum wirkungsvoll verbessert. Die emissivitätsmindernden Beschichtungen können bei hohen Außentemperaturen und Sonneneinstrahlung die von der gesamten Scheibe in Richtung des Innenraums abgestrahlte Wärmestrahlung zumindest teilweise reflektieren. Bei niedrigen Außentemperaturen können sie die aus dem Innenraum abgestrahlte Wärmestrahlung reflektieren und somit die Wirkung der kalten Scheibe als Wärmesenke verringern. Durch die emissivitätsmindernde Beschichtung wird der thermische Komfort im Innenraum weiter erhöht.

Die emissivitätsmindernde Beschichtung ist typischerweise ein transparenter Stapel von Dünnschichten. Die emissivitätsmindernde Beschichtung weist mindestens eine, bevorzugt genau eine elektrisch leitfähige Schicht auf, welche die IR-reflektierenden Eigenschaften bereitstellt. Die leitfähige Schicht ist bevorzugt auf Basis eines transparenten leitfähigen Oxids (TCO, *transparent conductive oxide*) ausgebildet, insbesondere Indium-Zinn-Oxid (ITO, *indium tin oxide*), alternativ Indium-Zink-Mischoxid (IZO), Gallium-dotiertes Zinnoxid (GZO), Fluor-dotiertes Zinnoxid (FTO, SnO₂:F), Antimon-dotiertes Zinnoxid (ATO, SnO₂:Sb) oder Niob-dotiertes Titanoxid (TiOz:Nb). Im Gegensatz zu Metallen sind TCOs nicht korrosionsanfällig, so dass sie auf der exponierten innenraumseitigen Oberfläche der Innenscheibe eingesetzt werden können. Außer der leitfähigen Schicht weist die Beschichtung typischerweise dielektrische Schichten auf (beispielsweise auf Basis von Siliziumoxid oder -nitrid), die insbesondere der Optimierung der optischen Eigenschaften (beispielsweise Lichttransmission) dienen oder als Barriereschichten zur Regulierung von Sauerstoffdiffusion bei der Abscheidung der Beschichtung dienen.

Die Verbundscheibe kann plan sein oder auch zylindrisch oder sphärisch gebogen. Insbesondere bei Fahrzeugscheiben sind sphärisch gebogene Verbundscheiben üblich, bei Gebäudeverglasungen plane Verbundscheiben.

Alle außenseitig des mindestens einen photovoltaischen Bauteils angeordneten Lagen sind bevorzugt klar, ohne Tönungen und Färbungen, so dass das Sonnenlicht möglichst ungehindert auf das photovoltaische Bauteil treffen kann. Sie weisen bevorzugt eine Lichttransmission von mindestens 70% auf, besonders bevorzugt mindestens 80%, ganz besonders bevorzugt mindestens 90%. Dies gilt insbesondere für die Außenscheibe und die erste thermoplastische Lage, über welche das mindestens eine photovoltaischen Bauteil mit der Außenscheibe verbunden ist. Die Außenscheibe ist bevorzugt aus Klarglas gefertigt und weist eine Lichttransmission von mindestens 90% im sichtbaren Spektralbereich auf. Auch die Frontelektrode ist bevorzugt transparent mit einer Lichttransmission von mindestens 80%, besonders bevorzugt mindestens 90%. Die erste thermoplastische Lage ist bevorzugt aus einer klaren Folie ausgebildet. Die weiteren thermoplastischen Lagen, die Innenscheibe und die Scheiben der Isolierungseinheit und die Aerogel-Lage können unabhängig voneinander klar, getönt oder gefärbt sein.

Die Verbundscheibe kann hergestellt werden, indem die einzelnen Lagen in der vorgesehenen Reihenfolge zu einem Schichtstapel gestapelt werden und anschließend miteinander laminiert werden. Hierzu können an sich bekannte Verfahren zum Einsatz kommen, beispielsweise Autoklavverfahren, Vakuumsackverfahren, Vakuumringverfahren, Kalanderverfahren, Vakuumlaminatoren oder Kombinationen davon. Die Verbindung von Außenscheibe und Innenscheibe erfolgt dabei üblicherweise unter Einwirkung von Hitze, Vakuum und/oder Druck.

Vor dem oder beim Stapeln der Schichten wird das mindestens eine photovoltaische Bauteil mit den erforderlichen elektrischen Anschlüssen versehen, wobei sich elektrische Leiter über die Seitenkante des Schichtstapels hinaus erstrecken, mittels derer das mindestens eine photovoltaische Bauteil später elektrisch kontaktiert werden kann, beispielsweise zum Anschluss an ein elektrisches System, eine Batterie oder einen oder mehrere einzelne elektrische Verbraucher. Ist eine Mehrzahl von photovoltaischen Bauteilen vorhanden, so werden diese (zumindest gruppenweise) elektrisch miteinander verbunden und dadurch verschaltet, so dass alle photovoltaischen Bauteile (oder jede Gruppe von photovoltaischen Bauteilen) durch gemeinsame elektrische Leiter extern elektrisch kontaktiert werden können.

Die Erfindung umfasst außerdem die Verwendung einer erfindungsgemäßen Verbundscheibe in Gebäuden oder in Fortbewegungsmitteln für den Verkehr auf dem Lande, in der Luft oder zu Wasser, insbesondere Fahrzeugscheibe oder Gebäudeverglasung. Die Verbundscheibe wird besonders bevorzugt als Fahrzeug-Dachscheibe verwendet, insbesondere als Dachscheibe eines Personenkraftwagens oder Lastkraftwagens.

Die Erfindung wird anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein. Es zeigen:
- Fig. 1: eine Draufsicht auf eine erste Ausgestaltung der erfindungsgemäßen Verbundscheibe,
- Fig. 2: einen Querschnitt entlang X-X' durch die Verbundscheibe aus Figur 1,
- Fig. 3: eine Draufsicht auf eine zweite Ausgestaltung der erfindungsgemäßen Verbundscheibe,
- Fig. 4: einen Querschnitt durch die Verbundscheibe aus Figur 3,
- Fig. 5: eine Draufsicht auf eine dritte Ausgestaltung der erfindungsgemäßen Verbundscheibe und
- Fig. 6: einen Querschnitt durch die Verbundscheibe aus Figur 5.

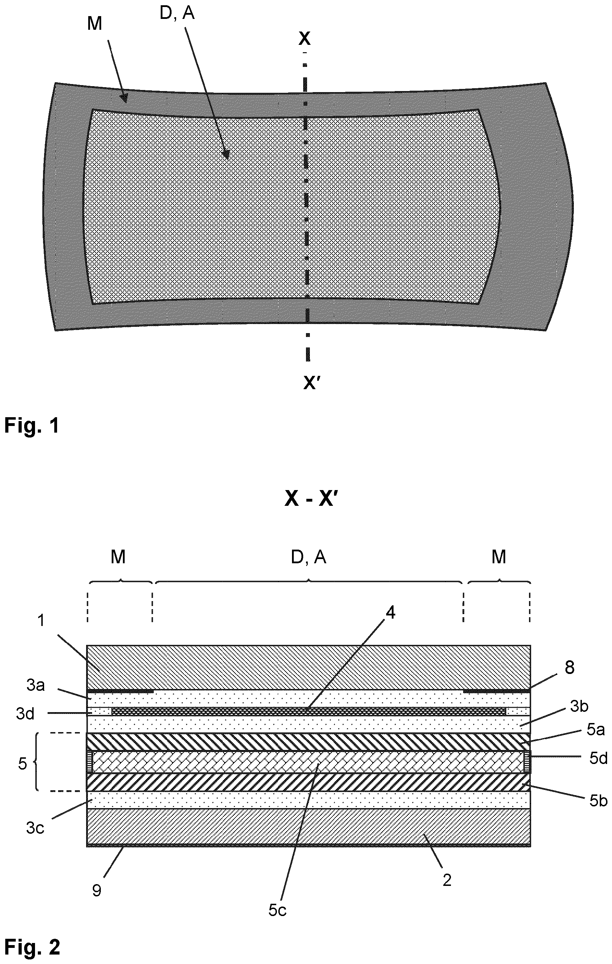

Figur 1 und Figur 2 zeigen je ein Detail einer ersten Ausgestaltung der erfindungsgemäßen Verbundscheibe. Die Verbundscheibe ist eine Fahrzeug-Dachscheibe. Die Verbundscheibe besteht aus einer Außenscheibe 1 und einer Innenscheibe 2, die durch eine Zwischenschicht miteinander verbunden sind. Die Außenscheibe 1 und die Innenscheibe 2 bestehen aus Kalk-Natron-Glas. Die Außenscheibe 1 weist eine Dicke von 2,1 mm auf, die Innenscheibe 2 eine Dicke von 1,6 mm. Die Außenscheibe 1 ist in Einbaulage der äußeren Umgebung, die Innenscheibe 2 dem Fahrzeug-Innenraum zugewandt.

Die Außenscheibe 1 weist einen opaken Maskierungsbereich M auf, der umlaufend im Randbereich angeordnet ist und einen zentralen transparenten Durchsichtsbereich D rahmenartig umgibt. Im Maskierungsbereich M ist ein schwarzer Abdeckdruck 8 auf der innenraumseitigen, zur Innenscheibe 2 hingewandten Oberfläche der Außenscheibe 1 aufgebracht. Der Durchsichtsbereich D definiert einen aktiven Bereich Ader Verbundscheibe, in dem elektrische Energie durch Photovoltaik gewonnen werden kann. Dazu ist ein photovoltaisches Bauteil 4 in die Zwischenschicht eingelagert. Das photovoltaische Bauteil 4 ist opak, deckt den aktiven Bereich A vollständig ab und erstreckt sich von da aus bis in den Maskierungsbereich M hinein. Die Verbundscheibe ist insgesamt also vollständig opak.

Die Zwischenschicht weist einen mehrlagigen Aufbau auf. Sie umfasst in der folgenden Reihenfolge ausgehend von der Außenscheibe 1:
- eine erste thermoplastische Lage 3a,
- eine Lage mit dem photovoltaischen Bauteil 4,
- eine zweite thermoplastische Lage 3b,
- eine Isolierungseinheit 5 und
- eine dritte thermoplastische Lage 3c, die an die Innenscheibe 2 angrenzt.

Die Lage mit dem photovoltaischen Bauteil 4 enthält eine thermoplastische Kapsellage 3d, welche rahmenartig um eine Aussparung ausgebildet ist, in welcher das photovoltaische Bauteil 4 angeordnet ist.

Die thermoplastischen Lagen 3a, 3b, 3c sind jeweils aus einer PVB-Folie mit einer Dicke von 0,76 mm ausgebildet. Die thermoplastische Kapsellage 3d ist aus einer PVB-Folie mit einer Dicke von 0,38 mm ausgebildet, was ungefähr der Dicke des photovoltaischen Bauteils 4 entspricht.

Die Lage mit dem photovoltaischen Bauteil 4 ist über die erste thermoplastische Lage 3a mit der Außenscheibe 1 verbunden und auf der gegenüberliegenden Seite über die zweite thermoplastische Lage 3b mit der Isolierungseinheit 5. Die Isolierungseinheit 5 ist wiederum auf der anderen Seite über die dritte thermoplastische Lage 3c mit der Innenscheibe 2 verbunden.

Das photovoltaische Bauteil 4 ist beispielsweise ein folienartiges Bauteil, umfassend eine dünne photovoltaisch aktive Absorberschicht zwischen einer Frontelektrode und einer Rückelektrode auf einer Trägerfolie. Es ist nur ein einzelnes großflächiges photovoltaisches Bauteil 4 vorhanden, welches in eine Mehrzahl verschalteter photovoltaischer Zellen aufgeteilt ist (durch geeignet positioniert Isolierungslinien in den Elektroden und der Absorberschicht). Die vollständige Abdeckung des aktiven Bereichs A kann alternativ aber auch durch eine Mehrzahl an photovoltaischen Bauteilen 4 erreicht werden, die miteinander verschaltet sind, wobei benachbarte Bauteile 4 bündig aneinander grenzen oder einander überlappen.

Das photovoltaische Bauteil 4 absorbiert Licht im sichtbaren Spektralbereich und wandelt es (teilweise) photovoltaisch in elektrischen Strom um, worauf seine Opazität beruht. Das photovoltaische Bauteil 4 wird dabei erwärmt. Es sendet daraufhin thermische Strahlung aus, welche teilweise in Richtung der Innenscheibe 2 und dem Fahrzeug-Innenraum gerichtet ist. Es trägt damit wesentlich zur sogenannten innenraumseitigen Emissivität der Verbundscheibe bei. Der Fahrzeug-Innenraum wird dadurch erwärmt, der thermische Komfort für die Fahrzeug-Insassen verringert. Die Isolierungseinheit 5 hat die Aufgabe, die innenraumseitige Emissivität zu verringern. Sie weist wärmedämmende Eigenschaften auf, welche sie dazu befähigen. Der Fahrzeug-Innenraum wird durch die Isolierungseinheit 5 gleichsam gegenüber der thermischen Strahlung des photovoltaischen Bauteils 4 (und auch gegenüber der thermischen Strahlung der Außenscheibe 1) abgeschirmt.

Die Isolierungseinheit 5 ist gebildet aus einer äußeren Scheibe 5a und einer inneren Scheibe 5b, zwischen denen eine Aerogel-Lage 5c angeordnet ist. Die Aerogel-Lage 5c ist beispielsweise mit jeweils einer nicht dargestellten Schicht eines Klebstoffs mit den Scheiben 5a, 5b verbunden. Der Zwischenraum zwischen den Scheiben 5a, 5b mit der Aerogel-Lage 5c ist evakuiert. Die äußere Scheibe 5a ist der Außenscheibe 1 zugewandt und ist über die zweite thermoplastische Lage 3b mit der Lage mit dem photovoltaischen Bauteil 4 verbunden. Die innere Scheibe 5b ist der Innenscheibe 2 zugewandt und über die dritte thermoplastische Lage 3c mit dieser verbunden. Die äußere Scheibe 5a und die innere Scheibe 5b sind jeweils aus chemisch vorgespanntem Aluminosilikatglas ausgebildet und weisen eine Dicke von jeweils 0,7 mm auf. Die Aerogel-Lage 5c weist eine Dicke von beispielsweise 2 mm auf. Im Randbereich ist zwischen der äußeren Scheibe 5a und der inneren Scheibe 5b außerdem eine umlaufende Randversiegelung 5d angeordnet, welche den evakuierten Zwischenraum mit der Aerogel-Lage 5c gasdicht abschließt. Die Randversiegelung 5d ist beispielsweise aus einem gasdichten Kunststoff oder aus Glas ausgebildet. Beispielsweise kann die Randversiegelung 5d in Form eines Glaspulvers oder -granulats in die Isolierungseinheit 5 eingebracht werden und die Scheiben 5a, 5b über das Glaspulver oder -granulat miteinander verschmolzen werden. Zur anschließenden Evakuierung kann die Randversiegelung 5d mit einem Ventil ausgestattet sein, welches nach der Evakuierung optional entfernt werden kann.

Die Aerogel-Lage 5c ist aus einem Silikat-Aerogel ausgebildet. Da die Verbundscheibe ohnehin opak ist, spielt es keine Rolle, ob die Aerogel-Lage 5c opak, transparent oder transluzent ist.

Auf der innenraumseitigen, von der Außenscheibe 1 und der Zwischenschicht abgewandten Oberfläche der Innenscheibe 2 ist eine emissivitätsmindernde Beschichtung 9 angeordnet. Solche Beschichtungen sind auch als LowE-Beschichtungen bekannt. Die emissivitätsmindernde Beschichtung 9 weist reflektierende Eigenschaften im mittleren IR-Bereich auf. Durch die emissivitätsmindernde Beschichtung 9 wird die innenraumseitigen Emissivität der Verbundscheibe weiter verringert. Insbesondere schirmt sie den Fahrzeug-Innenraum gegenüber der thermischen Strahlung der Innenscheibe 2 ab, auf welche die Aerogel-Lage 5 keinen Einfluss hat.

Die über die Seitenkante der Verbundscheibe hinausragenden elektrischen Anschlüsse des photovoltaischen Bauteils 4 sind der Einfachheit halber nicht dargestellt. Über diese Anschlüsse kann das photovoltaische Bauteil 4 mit der Bordelektrik des Fahrzeugs verbunden werden, beispielsweise um die Fahrzeug-Batterie zu laden.

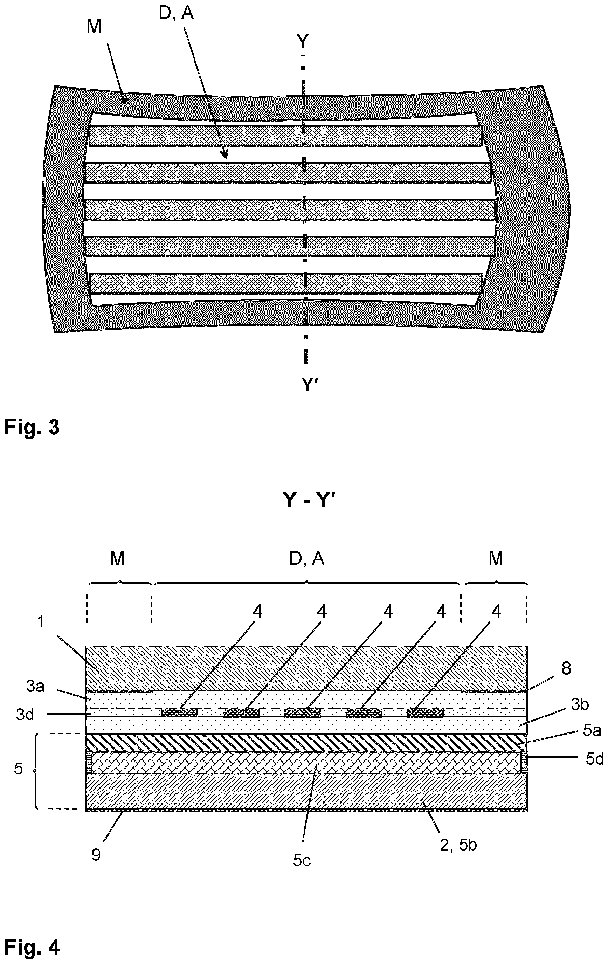

Figur 3 und Figur 4 zeigen je ein Detail einer zweiten Ausgestaltung der erfindungsgemäßen Verbundscheibe. Die zweite Ausgestaltung unterscheidet sich von der ersten Ausgestaltung der Figuren 1 und 2 grundlegend auf zweierlei Art: zum einen durch die Ausbildung des mindestens einen photovoltaischen Bauteils 4, zum anderen durch den Schichtaufbau der Verbundscheibe.

Es ist eine Mehrzahl photovoltaischer Bauteile 4 vorhanden, welche nur einen Teil des aktiven Bereichs A abdecken. Ein anderer Teil des aktiven Bereichs A weist keine photovoltaischen Bauteile 4 auf. Der aktive Bereich A weist fünf Bereiche auf, welche mit jeweils einem photovoltaischen Bauteil 4 versehen sind und welche durch Bereiche ohne photovoltaisches Bauteil 4 voneinander beabstandet sind. Alternativ ist es auch möglich, dass jeder der fünf Bereiche mit einer Mehrzahl von photovoltaischen Bauteilen 4 versehen ist, die miteinander verschaltet sind, wobei benachbarte Bauteile 4 bündig aneinander grenzen oder einander überlappen.

Die photovoltaischen Bauteile 4 (und damit die mit ihnen versehenen Bereiche der Verbundscheibe) sind auch in dieser Ausgestaltung opak. Durch die dazwischen befindlichen und die randständigen Bereiche ohne photovoltaische Bauteile 4 kann aber Sonnenlicht in den Fahrzeug-Innenraum dringen. Die Aerogel-Lage 5c der Isolierungseinheit 5 sollte daher nicht opak sein, sondern transparent oder transluzent.

Die Lage mit den photovoltaischen Bauteilen 4 enthält auch in der zweiten Ausgestaltung, neben den photovoltaischen Bauteilen 4 selbst, eine thermoplastischen Kapsellage 3d. Die thermoplastische Kapsellage 3d ist wieder rahmenartig um die Gesamtheit der photovoltaischen Bauteile 4 angeordnet und zusätzlich in den Zwischenräumen zwischen benachbarten photovoltaischen Bauteilen 4. Anders ausgedrückt bildet die thermoplastische Kapsellage 3d einen Rahmen um jedes einzelne photovoltaische Bauteil 4.

Was den Schichtaufbau betrifft, so unterscheidet sich die zweite Ausgestaltung von der ersten Ausgestaltung der Figuren 1 und 2 dadurch, dass die Isolierungseinheit 5 nicht zwischen der Außenscheibe 1 und einer separaten Innenscheibe 2 angeordnet ist. Stattdessen ist die Innenscheibe 2 Teil der Isolierungseinheit 5 und bildet auch deren innere Scheibe 5b.

Die Verbundscheibe umfasst in der angegebenen Reihenfolge:
- die Außenscheibe 1,
- eine erste thermoplastische Lage 3a,
- die Lage mit den photovoltaischen Bauteilen 4,
- eine zweite thermoplastische Lage 3b und
- die Isolierungseinheit 5.

Die Außenscheibe 1 mit dem Abdeckdruck 8, die erste thermoplastische Lage 3a und die zweite thermoplastische Lage 3b sind genauso ausgebildet wie in der Ausgestaltung der Figur 2. Auf die Unterschiede hinsichtlich der Lage mit den photovoltaischen Bauteilen 4 wurde bereits hingewiesen.

Die äußere Scheibe 5a, die Aerogel-Lage 5c und die Randversiegelung 5d der Isolierungseinheit 5 sind ebenfalls genauso ausgebildet wie in der Ausgestaltung der Figur 2. Auch die Innenscheibe 2 ist wie in Figur 2 eine Scheibe aus Kalk-Natron-Glas mit einer Dicke von 1,6 mm. Sie bildet hier auch die innere Scheibe 5b der Isolierungseinheit 5 und ist über die Aerogel-Lage 5c und die Randversiegelung 5d mit der äußeren Scheibe 5a verbunden. Auf der von der Aerogel-Lage 5c abgewandten, innenraumseitigen Oberfläche der Innenscheibe 2 ist wiederum eine emissivitätsmindernde Beschichtung 9 angeordnet.

Soll die Lichteinstrahlung in den Fahrzeug-Innenraum verringert werden, so können die Innenscheibe 2, die zweite thermoplastische Lage 3b, die äußere Scheibe 5a und/oder die Aerogel-Lage 5c getönt oder gefärbt ausgestaltet werden. Die Außenscheibe 1 und die erste thermoplastische Lage 3a sollten klar sein, um die Ausbeute der photovoltaischen Bauteile 4 zu optimieren.

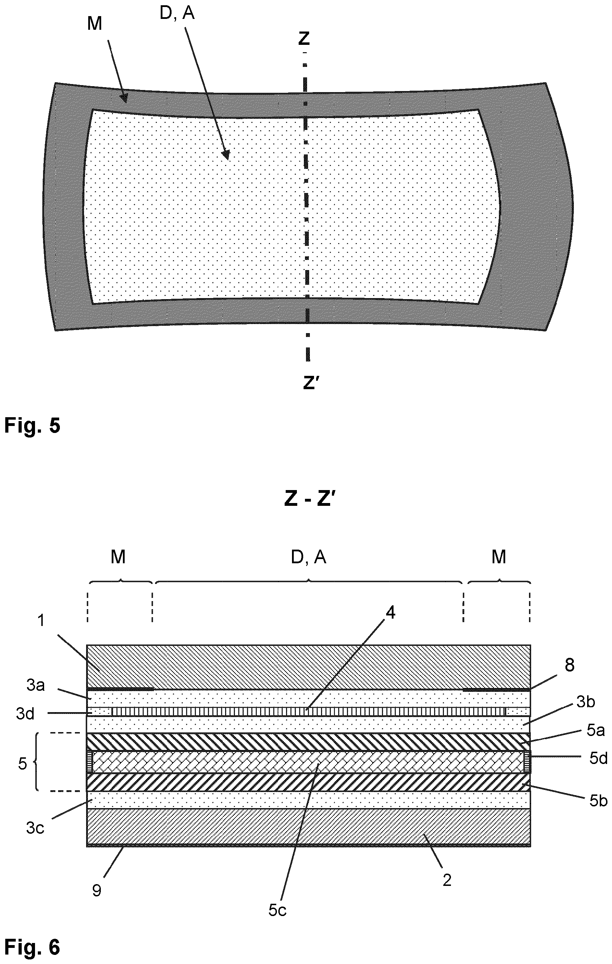

Figur 5 und Figur 6 zeigen je ein Detail einer dritten Ausgestaltung der erfindungsgemäßen Verbundscheibe. Die Verbundscheibe ist ähnlich aufgebaut wie in der ersten Ausgestaltung der Figuren 1 und 2. Insbesondere sind die Außenscheibe 1 mit dem Abdeckdruck 8, die Innenscheibe 2 mit der emissivitätsmindernden Beschichtung 9, die Isolierungseinheit 5 und die thermoplastischen Lagen 3a, 3b, 3c ebenso ausgestaltet wie in den Figuren 1 und 2. Im Folgenden wird lediglich auf die Unterschiede zur ersten Ausgestaltung eingegangen.

Wie bei der ersten Ausgestaltung ist nur ein einzelnes (beispielsweise folienartiges) photovoltaisches Bauteil 4 vorhanden, welches den aktiven Bereich A der Verbundscheibe vollständig abdeckt. Die vollständige Abdeckung des aktiven Bereichs A kann alternativ aber auch durch eine Mehrzahl an photovoltaischen Bauteilen 4 erreicht werden, die miteinander verschaltet sind, wobei benachbarte Bauteile 4 bündig aneinander grenzen oder einander überlappen. Die Lage mit dem photovoltaischen Bauteil 4 enthält auch in der dritten Ausgestaltung, neben dem photovoltaischen Bauteil 4 selbst, eine thermoplastischen Kapsellage 3d. Das photovoltaische Bauteil ist in einer Aussparung der Kapsellage 3d angeordnet, so dass die Kapsellage 3d das photovoltaisch Bauteil 4 wieder rahmenartig umgibt. Das photovoltaische Bauteil ist wieder ein folienartiges Bauteil.

Im Gegensatz zur ersten Ausgestaltung ist das photovoltaische Bauteil 4 nicht opak, sondern transparent. Dies wird insbesondere dadurch erreicht, dass die photovoltaisch aktive Absorberschicht im sichtbaren Spektralbereich nicht oder kaum empfindlich ist und Sonnenlicht absorbiert, sondern im nahen infraroten Spektralbereich. Die Aerogel-Lage 5c der Isolierungseinheit 5 ist transparent oder transluzent ausgebildet, so dass der aktive Bereich A der Verbundscheibe insgesamt transparent beziehungsweise transluzent ist.

Soll die Lichteinstrahlung in den Fahrzeug-Innenraum verringert werden, so können die Innenscheibe 2, die zweite thermoplastische Lage 3b, die Scheibe 5a, 5b der Isolierungseinheit 5, die Aerogel-Lage 5c und/oder die dritte thermoplastische Lage 3c getönt oder gefärbt ausgestaltet werden.

In allen Ausgestaltungen kann die Isolierungseinheit 5 auch rahmenartig von einer weiteren thermoplastischen Kapsellage umgeben sein, welche im Maskierungsbereich M angeordnet ist.

Die hier dargestellten Kombinationen aus der Ausgestaltung des mindestens einen photovoltaischen Bauteils 4 und der Ausgestaltung des Schichtaufbaus der Verbundscheibe sind lediglich beispielhaft gewählt. Ein Schichtaufbau wie bei der zweiten Ausgestaltung in Figur 4, mit der Isolierungseinheit 5, deren innere Scheibe 5b identisch mit der Innenscheibe 2 ist, kann ebenso in Verbindung mit einem vollflächigen opaken photovoltaischen Bauteil 4 wie in der ersten Ausgestaltung der Figuren 1 und 2 oder mit einem vollflächigen transparenten photovoltaischen Bauteil 4 wie in der dritten Ausgestaltung der Figuren 5 und 6 eingesetzt werden. Umgekehrt kann ein Schichtaufbau mit einer Isolierungseinheit 5 zwischen einer Außenscheibe 1 und einer separaten Innenscheibe 2, wie in der ersten und dritten Ausgestaltung der Figuren 1 und 2 sowie 5 und 6, auch in Verbindung mit opaken, den aktiven Bereich A nur teilweise bedeckenden photovoltaischen Bauteilen 4 wie in der zweiten Ausgestaltung der Figuren 3 und 4 eingesetzt werden.

### Bezugszeichenliste:

- (1): Außenscheibe der Verbundscheibe
- (2): Innenscheibe der Verbundscheibe
- (3a): erste thermoplastische Lage
- (3b): zweite thermoplastische Lage
- (3c): dritte thermoplastische Lage
- (3d): thermoplastische Kapsellage
- (3e): vierte thermoplastische Lage
- (4): photovoltaisches Bauteil
- (5): Isolierungseinheit
- (5a): äußere Scheibe der Isolierungseinheit 5
- (5b): innere Scheibe der Isolierungseinheit 5
- (5c): evakuierte Aerogel-Lage der Isolierungseinheit 5
- (5d): Randversiegelung

- (8): Abdeckdruck
- (9): emissivitätsmindernde Beschichtung (LowE-Beschichtung)

- (D): Durchsichtsbereich der Außenscheibe 1
- (M): Maskierungsbereich der Außenscheibe 1
- (A): aktiver Bereich der Verbundscheibe

- X - X': Schnittlinie
- Y - Y': Schnittlinie
- Z - Z': Schnittlinie

## Patentansprüche

1. Verbundscheibe, umfassend eine Außenscheibe (1) und eine Innenscheibe (2), die flächig miteinander verbunden sind,
wobei mindestens ein photovoltaisches Bauteil (4) zwischen der Außenscheibe (1) und der Innenscheibe (2) in die Verbundscheibe eingelagert ist
und wobei die Verbundscheibe eine Isolierungseinheit (5) aufweist, welche in der angegebenen Reihenfolge
- eine zur Außenscheibe (1) hingewandte äußere Scheibe (5a),
- eine evakuierte Aerogel-Lage (5c) und
- eine innere Scheibe (5b)
umfasst,
und wobei
(i) die Isolierungseinheit (5) zwischen der Außenscheibe (1) und der Innenscheibe (2) in die Verbundscheibe eingelagert ist und einen geringeren Abstand zur Innenscheibe (2) aufweist als das mindestens eine photovoltaische Bauteil (4) oder
(ii) die Innenscheibe (2) der Verbundscheibe die innere Scheibe (5b) der Isolierungseinheit (5) bildet.

2. Verbundscheibe nach Anspruch 1 gemäß Variante (i), welche in der angegebenen Reihenfolge umfasst:
- die Außenscheibe (1),
- eine erste thermoplastische Lage (3a),
- das mindestens eine photovoltaische Bauteil (4),
- eine zweite thermoplastische Lage (3b),
- die Isolierungseinheit (5),
- eine dritte thermoplastische Lage (3c) und
- die Innenscheibe (2).

3. Verbundscheibe nach Anspruch 1 gemäß Variante (ii), welche in der angegebenen Reihenfolge umfasst:
- die Außenscheibe (1),
- eine erste thermoplastische Lage (3a),
- das mindestens eine photovoltaische Bauteil (4),
- eine zweite thermoplastische Lage (3b),
- die Isolierungseinheit (5).

4. Verbundscheibe nach einem der Ansprüche 1 bis 3, wobei die Aerogel-Lage (5c) eine Dicke von 0,1 mm bis 10 mm aufweist, besonders bevorzugt von 0,5 mm bis 6 mm, ganz besonders bevorzugt von 1 mm bis 4 mm.

5. Verbundscheibe nach einem der Ansprüche 1 bis 4, wobei die Aerogel-Lage (5c) auf Basis eines Silikat-Aerogels oder Polymer-Aerogels ausgebildet ist.

6. Verbundscheibe nach einem der Ansprüche 1 bis 5, wobei die Aerogel-Lage (5c) auf Basis eines Aerogels ausgebildet ist, welches eine Porosität von 50% bis 99,98% aufweist, bevorzugt von 80% bis 99%.

7. Verbundscheibe nach einem der Ansprüche 1 bis 6, wobei in der Aerogel-Lage (5c) ein Druck von höchstens 10 mbar herrscht, bevorzugt höchstens 1 mbar.

8. Verbundscheibe nach einem der Ansprüche 1 bis 7, wobei die Außenscheibe (1) einen transparenten Durchsichtsbereich (D) aufweist, der einen aktiven Bereich (A) der Verbundscheibe definiert, und wobei die Isolierungseinheit (5) zumindest den aktiven Bereich (A) vollständig abdeckt.

9. Verbundscheibe nach einem der Ansprüche 1 bis 8, wobei die Isolierungseinheit (5) mit einer Randversiegelung (5d) versehen ist, welche aus Glas, einem Metall oder einer Metalllegierung oder einem gasdichten Kunststoff ausgebildet ist.

10. Verbundscheibe nach einem der Ansprüche 1 bis 9, wobei das mindestens eine photovoltaische Bauteil (4)
- opak ist und nur einen Teil des aktiven Bereichs (A) abdeckt oder
- transparent ist und den aktiven Bereich (A) bevorzugt vollständig abdeckt und wobei die Aerogel-Lage (5c) transparent oder transluzent ist.

11. Verbundscheibe nach einem der Ansprüche 1 bis 10, wobei die äußere Scheibe (5a) und die innere Scheibe (5b) aus Glas gefertigt sind.

12. Verbundscheibe nach einem der Ansprüche 1 bis 11
- gemäß der Variante (i), wobei die äußere Scheibe (5a) und die innere Scheibe (5b) eine Dicke von 0,3 mm bis 3 mm aufweisen, bevorzugt von 0,5 mm bis 1,5 mm
oder
- gemäß der Variante (ii), wobei die äußere Scheibe (5a) eine Dicke von 0,3 mm bis 3 mm aufweist, bevorzugt von 0,5 mm bis 1,5 mm.

13. Verbundscheibe nach einem der Ansprüche 1 bis 12, wobei die von Außenscheibe (1) abgewandte Oberfläche der Innenscheibe (2) mit einer emissivitätsmindernden Beschichtung (9) versehen ist.

14. Verbundscheibe nach einem der Ansprüche 1 bis 13, wobei die Außenscheibe (1) und die Innenscheibe (2) aus Kalk-Natron-Glas ausgebildet sind und bevorzugt eine Dicke von 1 mm bis 3 mm aufweisen.

15. Verwendung einer Verbundscheibe nach einem der Ansprüche 1 bis 14 als Fahrzeugscheibe oder Gebäudeverglasung, bevorzugt als Fahrzeug-Dachscheibe.
